# EUROPEAN PATENT SPECIFICATION

(11) **EP 3 671 876 B1**
(45) Date of publication and mention of the grant of the patent: **01.12.2021**
(21) Application number: 18213335.5
(22) Date of filing: 18.12.2018
(51) Int. Cl.: H01L 49/02

(54) **METHOD AND INDUCTIVE DEVICE**
VERFAHREN UND INDUKTIVE VORRICHTUNG
PROCÉDÉ ET DISPOSITIF INDUCTIFS

(43) Date of publication of application: 24.06.2020
(73) Proprietor: ABB Schweiz AG, 5400 Baden (CH)
(72) Inventor: Disselnkötter, Rolf, 69256 Mauer (DE); Hozoi, Adrian, 68219 Mannheim (DE)
(74) Representative: Maiwald Patent- und Rechtsanwaltsgesellschaft mbH

(56) References cited:
- US-A- 4 280 162
- US-A1- 2011 248 812
- US-A1- 2018 268 982

## Description

### FIELD OF THE INVENTION

The invention relates to a method for operating an inductive device and an inductive device.

### BACKGROUND OF THE INVENTION

Soft magnetic materials are characterized in that they are easily magnetized or demagnetized. They feature low coercivity and high permeability and are suitable for conducting or channelling the magnetic flux. Low coercivity also ensures low magnetic losses and provides linear and reproducible magnetic response of the magnetic core. The magnetic response characterizes the relationship between the magnetic flux density and the magnetic field and can be determined for example from magnetic hysteresis measurements or from electrical impedance measurements.

Magnetic cores made from soft magnetic materials are widely applied in the construction of inductive devices employed for sensing or transforming some physical parameter. In the general case of an inductive device, the magnetic core can be described as a structure made from soft magnetic material being inductively coupled to one or more electrical windings of the sensor. The high permeability of the magnetic core typically ensures good magnetic coupling and allows achieving high inductance values in small volumes.

The principle of inductive devices employed for sensing or transformer applications would typically rely on ensuring a desirable dependence between the physical quantity to be measured and one or more electrical signals provided to or from the device. Ideally, the dependence between the physical quantity to be measured and the electrical signals to be measured shall be stable and linear.

However, even soft magnetic materials are affected by magnetic hysteresis and magnetic non-linearity, which have negative impact on the magnetic response the magnetic core. The magnetic core can be a magnetic core arrangement comprising multiple magnetic parts. Magnetic hysteresis typically leads to phase and magnitude errors in inductive devices operated with AC signals. In addition, magnetic hysteresis causes remanence offset errors in the case of inductive devices operating also with DC signals, such as current sensors including a magnetic core. The errors related to magnetic hysteresis depend on the history of magnetic fields experienced by the magnetic core, including the field applied at the time when the measurement is being performed. The magnetic hysteresis degrades thus both the reproducibility and the linearity of the measurement.

Soft magnetic materials are subject to further non-linear effects related to the dependence of their magnetic permeability on the magnitude of the magnetic field. This is the case even when the magnetic materials are operated well below their saturation limit. Generally, the value of the initial permeability, which is the permeability measured at weak magnetic field in demagnetized state, e.g. at 0.1 A/m, is smaller than the maximum value of the permeability, which usually occurs at stronger magnetic field having a value greater than the coercivity of the material. Further, the value of the permeability usually depends on the magnetization state of the magnetic core. The value of the permeability is thus affected by the history of the inductive device and may be influenced for example by the history of electrical signals applied or produced to or in the device, the history of internal magnetic fields and/or the history of external magnetic fields. This behaviour cause measurement errors in inductive devices, which are dependent on the magnetization state of the magnetic core. The errors can be severe, especially in voltage transformers, current transformers, and current sensors.

The magnetic hysteresis and the non-linear effects of the magnetic core limit the performance of inductive devices, which can be practically achieved. Generally, the performance can be engineered within limited margins by optimizing the construction of the inductive device and the selection of soft magnetic materials. Examples of soft magnetic materials commonly employed in inductive devices are iron and low-carbon steels, iron-silicon alloys, nickel-iron alloys, amorphous alloys, nanocrystalline alloys, and ferrites. Selecting a specific material depends on many factors such as desired performance of the inductive device like accuracy, operation frequency, and operation range, but also on the price of the material and its suitability for specific construction types and manufacturing processes. For example, amorphous alloys or nanocrystalline alloys are only available in thin ribbons having the thickness typically comprised between 20 µm and 40 um, being most suitable for magnetic cores of tape-wound type. Ferrite magnetic core structures are commonly fabricated by pressing and sintering. Nickel-iron alloys can be produced with very low coercivity and are available in many forms such as bulk, bar, sheet, or thin ribbon. However, they have limited saturation magnetic flux density and are very costly.

It is known that adding one or more air gaps into the magnetic core decreases the remanence of the magnetic core because of self-demagnetization and reduces the non-linear behaviour of the magnetic core because of the linear reluctance of the air gaps. However, a magnetic core arrangement provided with air gaps would still preserve a certain amount of remanence and non-linear behaviour. The coercivity cannot be improved by using air gaps. Inductive devices employing gapped magnetic core arrangements are thus still affected by accuracy errors related to non-linear and hysteresis effects. Employing air gaps reduces the inductance of the magnetic core, which is not always desired, and tradeoffs between magnetic core inductance and linearity are sometimes necessary.

Technically, it is possible to reduce the impact of hysteresis effects in inductive devices by applying a demagnetization routine to the magnetic core. The demagnetization routine usually relies on applying to the magnetic core an alternating magnetic field whose magnitude is initially high and progressively drops until vanishing. The demagnetization sequence has thus a finite time duration and for proper outcome, it requires that no other magnetic field is applied to the magnetic core at the same time. Good execution of the demagnetization sequence allows reaching a demagnetized magnetic state of the magnetic core, which is like resetting the magnetic induction in the magnetic core and the permeability of the magnetic core, which both depend on the magnetization state of the magnetic core. The need of performing demagnetization emphasizes the severity of the errors caused by magnetic hysteresis of the magnetic core in inductive devices. However, demagnetization cannot eliminate hysteresis effects and does not address non-linear effects related to the dependence of the magnetic permeability on the magnitude of the magnetic field. Demagnetization allows reaching a demagnetized state of the magnetic core but it does not allow maintaining it; it operates like a reset function for the magnetization state of the magnetic core. In demagnetized state, the magnetic permeability of a magnetic material would still vary with the magnitude of the magnetic field, as shown for example by the different values between the initial permeability and the maximum permeability.

Magnetic hysteresis and Barkhausen noise are related to irreversible magnetization processes, which are mostly related to irreversible magnetic domain-wall motion. Magnetization processes related to domain-wall motion are responsible for the relatively low initial permeability encountered in many magnetic materials. Irreversible magnetization processes happen to some extent in any soft magnetic material or magnetic core comprising the same. Common demagnetization techniques only bring the magnetic core to a demagnetized state but do not address irreversible magnetization effects. Irreversible magnetization jumps related to domain-wall pinning are still possible after demagnetization and they would cause magnetization jumps, which would typically cause accuracy errors in an inductive device. Such magnetization jumps would be random and may be triggered for example even by weak external magnetic fields or by other factors such as thermal or mechanical, e.g. vibration.

There are also practical disadvantages, which limit the interest of demagnetization routines. The demagnetization sequence must be triggered externally and it interrupts the normal operation of the device, which is usually not desired. Further, the method would require the inductive device to feature additional interfacing and external control to trigger the demagnetization cycle. Deciding when demagnetization is needed may not be straightforward and performing demagnetization is not always possible because the normal operation of the device would need to be interrupted. In order to run a demagnetization sequence, the operation of the inductive device must be interrupted and all magnetic fields other than that employed for demagnetization must be set to null, which may not be desired or possible in practical situations. Common demagnetization techniques require specific control interfaces and must be well understood by the user in order to guarantee proper performance and to avoid miss manipulation. Employing solutions based on demagnetization would increase the application complexity and cost, while addressing only partly the technical problems.

US 4 280 162 A describes a ground fault circuit interrupter.

### DESCRIPTION OF THE INVENTION

It is therefore an objective of the invention to provide a cost-efficient method for operating an inductive device and an inductive device, in particular for sensing applications or transformer applications, with improved magnetic linearity. This objective is achieved by a method according to the claim 1 and an inductive device according to claim 7. Further preferred embodiments are evident from the dependent patent claims.

According to the invention, the method for operating an inductive device with a magnetic core comprises the steps:
Operating the inductive device by an electrical main operation signal with a main operation frequency producing a magnetic main operation field in the magnetic core; and
Providing an alternating electrical bias signal with a bias frequency higher than the main operation frequency producing a magnetic bias field in the magnetic core superimposed to the magnetic main operation field, such that non-linear and/or hysteresis effects in the magnetic core are shifted from the main operation frequency to the bias frequency. The magnetic bias field is simultaneously superimposing the magnetic main operation field.

Thus, a high frequency magnetic bias field is produced in the magnetic core and provides the energy to alternately switch the magnetization in the magnetic core, allowing to shift non-linear and/or hysteresis effects from the main operation frequency of the main operation signal to the high frequency of the bias signal. Thus, the magnetic response of the magnetic core becomes close to ideal at the main operation frequency of the main operation signal. In other words, it can be said that the main operation signal experiences a magnetic response of the magnetic core, which is linear and free of hysteresis.

During normal operation of the inductive device, the magnetic core is subject to the main magnetic operation field related to the main electrical signal applied to or produced in the inductive device. The electrical main operation signal can be characterized by a main operation frequency, also called characteristic frequency, where optimum magnetic performance of the magnetic core is wanted. Physically, it is not possible to eliminate the magnetic hysteresis, Barkhausen noise, and non-linear effects, which are specific to any magnetic core and/or soft magnetic material.

However, by using the bias signal the negative effects are shifted to the bias frequency, which is higher than the main operation frequency of the magnetic main operation field where optimum magnetic performance of the magnetic core is desired. This is achieved by producing in the magnetic core a high frequency magnetic bias field, which provides the necessary energy to alternately switch the irreversible magnetization such that the magnetic main operation field present in the magnetic core must mainly drive reversible magnetization processes. If the frequency of the magnetic bias field is much higher than that of the magnetic main operation field, a significant amount of the magnetization characterized by irreversible magnetization is switched by the magnetic bias field.

Thus, the magnetic main operation field must not deal with the losses, hysteresis, and non-linear effects caused by irreversible magnetization processes in the magnetic core. These undesired effects are therefore shifted and consumed at the high bias frequency. The magnetization process behaves like an ideal reversible magnetization for the magnetic main operation field. An almost ideal magnetic response of the magnetic core is consequently achieved at the magnetic main operation field, while biasing is active, where hysteresis and non-linear effects are significantly reduced. The magnetic hysteresis and the Barkhausen noise are practically eliminated or significantly reduced, and the permeability is almost constant over a wide range of the magnetic field, excluding saturation. That is, the initial permeability is approximately equal to the maximum permeability resulting in linear magnetic response of magnetic core as long as saturation is not reached. The operation range of the magnetic core is thus extended to extremely low field values, allowing excellent accuracy of the inductive device even at very weak magnetic fields.

The term "higher frequency" preferably means that the frequency of the magnetic bias field is significantly higher than the main operation frequency of the magnetic main operation field.

Preferably, the high frequency magnetic bias field brings the magnetic core in a linear or almost linear operating regime. Saturation of the magnetic core is not desired but maximizing the operating range of the magnetic core from very low to high magnetic fields.

Preferably, the high frequency magnetic bias field can be continuously active in the background of the magnetic main operation field in the magnetic core. However, it is also possible to enable the magnetic bias field only when high performance of the device is needed, which could be triggered by the inductive device itself or be instructed externally using some suitable interface. For example, in the case of a transformer or of a current sensor, the inductive device may enable the bias signal based on the value of a secondary signal, being related to the main primary signal. It is also possible to modulate or vary the magnitude of the bias signal, for example, depending on operating conditions.

Unlike common demagnetization, the high frequency magnetic bias field runs in the background of the main device operation, simultaneously to the main electrical signal. It does not require interrupting the operation of the inductive device and it allows to reliably and seamlessly remove the magnetic hysteresis and non-linear effects experienced by the magnetic main operation field in the magnetic core. The operation range of the magnetic core is thus extended to extremely low field values. In addition, it eliminates the magnetization jumps caused for example by irreversible magnetic domain-wall motion.

In a preferred embodiment, the bias frequency is at least ten times higher than the main operation frequency. Preferably, the bias frequency is at least one hundred times higher than the main operation frequency. Further preferably, the bias frequency is between 100 Hz and 50 kHz.

If the frequency of the magnetic bias field is much higher than the magnetic main operation field, a significant amount of the irreversible magnetization is switched by the magnetic bias field and no longer by the magnetic main operation field. It is thus sensitive to select a frequency of the magnetic bias field, which is at least 10 times higher than the main operation frequency of the magnetic main operation field. In some applications, it can be beneficial to use a ratio between the main operation frequency and the bias frequency of even larger than 100. This is particularly the case for inductive devices, where excellent operation is required at the main operation frequency, but operation with relaxed requirements is still needed over a frequency range exceeding the main operation frequency.

In the case, where optimum magnetic performance of the magnetic core is desired at DC, the main operation frequency can be considered to be 0.1 Hz. In the case, where optimum magnetic performance of the magnetic core is desired over a frequency range, the main operation frequency can be represented by the lowest frequency in the range. For example, in the case of a closed loop current sensor the main operation frequency is usually close to DC, e.g. 0.1 Hz, as low offset and good DC linearity are typically desired. However, sufficiently good operation may also be needed, for example, in a range from 0.1 Hz to 100 Hz. For a closed loop current sensor, the bias frequency can be selected to be mainly comprised in a range from 100 Hz to 50 kHz. In other example related to voltage or current transformers having a nominal operation frequency of 50 Hz, the bias frequency may be selected in a range from 500 Hz and 50 kHz. One additional example relates to variable inductance sensor, which typically operates with main frequencies comprised between 50 Hz and 50 kHz. In the case of variable an inductance sensors, the bias frequency preferably lies in a range between 500 Hz and 500 kHz.

In a preferred embodiment, the magnitude of the magnetic bias field is at least 0.2 A/m. Preferably, the magnitude of the magnetic bias field is larger than a coercivity of the magnetic core.

The high frequency magnetic bias field must provide sufficient energy to switch the magnetic core magnetization, which is related to irreversible magnetization processes. The magnitude of the magnetic bias field must be thus sufficiently large. In practice, the magnitude of the magnetic bias field would be engineered based on the magnetic properties of the magnetic core and on the performance improvement which is desired. If it is desired to increase the value of the initial permeability and to reduce the Barkhausen noise, it is sufficient to target a magnitude of the magnetic bias field having a peak value equal to or larger than 0.2 A/m, or greater than 50% the coercivity of the magnetic core. If it is needed to maximize the magnetic performance of the magnetic core and to eliminate the effects of the magnetic hysteresis, it is appropriate to employ a magnetic bias field whose magnitude is greater than the coercivity of the magnetic core.

In some cases, magnetic saturation is deduced from a strong drop of the inductance value of the magnetic core, e.g. by 50%. However, the inductance of the magnetic core also drops when only part of the magnetic core saturates, which would not necessarily make the magnetic core not useable. In such cases, the inductance value drops in several steps and it is necessary to consider the drop, which brings the magnetic core into non-operational state.

The method using high frequency biasing addresses the magnetic problems directly at the source by shifting the irreversible magnetization effects from the low frequency of the main operation signal to the high frequency of the bias signal. Relative to the main operation signal, the hysteresis of the magnetic core is then practically eliminated and very linear response of the magnetic core is achieved with smooth magnetization curve and almost constant permeability from very low field up to saturation.

In a preferred embodiment, the magnetic bias field produces a bias magnetic flux density in the magnetic core, wherein the bias magnetic flux density does not exceed 30% of a saturation flux density of the magnetic core.

If the target is improving the linear operation of the magnetic core at the main operation frequency of the magnetic main operation field, the magnitude of the magnetic bias field is significantly smaller than of the field, which would cause magnetic saturation of the magnetic core. That is, the magnetic flux density produced in the magnetic core by the magnetic bias field must be smaller than 30% of the saturation magnetic flux density of the magnetic core. The saturation magnetic flux density is the magnetic flux density where a significant portion of the magnetic core saturates, making the magnetic core not useable for the intended application. The magnetic field and/or the magnetic flux density can be determined from hysteresis measurements (B-H curves) or from impedance measurements of the magnetic core. For example, the previous conditions is equivalent to saying that the bias current must be smaller than 30% of the saturation current applied in the same winding which would cause magnetic saturation of the magnetic core.

In a preferred embodiment, the magnitude of the magnetic bias field does not exceed four times the coercivity of the magnetic core and/or the bias magnetic flux density does not exceed 10% of the saturation flux density of the magnetic core.

In order to maximize the operation range of the magnetic core and to provide a practical solution, which is simple to implement using inexpensive signal sources and/or drivers, it is beneficial to keep the magnitude of the magnetic bias field as low as it is needed to provide the desired improvements. It is thus practical to employ a high frequency magnetic bias field whose magnitude is smaller than four times the value of the coercivity of the magnetic core. Alternatively, the magnetic flux density produced in the magnetic core by the magnetic bias field may be smaller than 10% of the saturation magnetic flux density of the magnetic core.

For many practical applications, the magnitude of the magnetic bias field can be selected in a range from 0.5 A/m to 20 A/m and the exact value would depend on the magnetic material, magnetic core structure, application, and desired performance.

In a preferred embodiment the bias signal is a periodic waveform, in particular a sine, square or saw-tooth, or a band pass filtered white noise.

In a simple implementation, the bias signal can be a periodic common waveform such as sine, square, or saw-tooth. However, if it is desired to avoid spurious signals caused by the bias signal in a secondary signal of the inductive device, it is possible to employ waveforms having wide frequency spectrum. Preferably, frequency spreading techniques are employed to distribute the power of the bias signal over a wide frequency spectrum. This allows minimizing the power density of the bias current, which is needed for reaching a sufficiently high magnitude of the current, such that the peak magnitude of the magnetic bias field overcomes the coercivity of the magnetic core.

According to the invention, the inductive device comprises a magnetic core and an alternating bias source, wherein the inductive device is configured to be operated by an electrical main operation signal with a main operation frequency producing a magnetic main operation field in the magnetic core. The alternating bias source is configured to provide an electrical bias signal with a bias frequency higher than the main operation frequency producing a magnetic bias field in the magnetic core superimposed to the magnetic main operation field, such that non-linear and/or hysteresis effects in the magnetic core are shifted from the main operation frequency to the bias frequency. The magnetic bias field is simultaneously superimposing the magnetic main operation field.

An almost ideal magnetic response of the magnetic core is provided for the main electrical signal, allowing to implement inductive devices with much better performance.

Because the method allows improving the response of the magnetic core, it also enables using materials which have less appealing magnetic properties but which are better suitable for manufacturing and which are more economical. New structures of inductive devices are thus possible and even lower overall cost. For example, inductive devices with better performance and lower cost compared to known technology can be reached.

The high frequency bias solution allows drastic improvement of the accuracy of closed loop current sensors. The magnetic offset and magnetic offset jumps are practically eliminated and the linearity is improved. Reaching DC errors, which are around an order of magnitude lower compared to common implementation is possible. The AC linearity and the Barkhausen noise at low and medium frequency are also significantly improved. The solution disclosed can be implemented with moderate additional complexity and cost, while the much improved accuracy allows for new applications of closed loop current sensors such as for electricity metering. Electricity meters for DC and/or AC applications can be thus conveniently designed and produced.

In a preferred embodiment, the bias frequency is at least ten times higher than the main operation frequency. Preferably, the bias frequency is at least one hundred times higher than the main operation frequency. Further preferably, the bias frequency is between 100 Hz and 50 kHz.

In a preferred embodiment, the magnitude of the magnetic bias field is at least 0.2 A/m. Preferably, the magnitude of the magnetic bias field is larger than a coercivity of the magnetic core.

In a preferred embodiment, the magnetic bias field produces a bias magnetic flux density in the magnetic core, wherein the bias magnetic flux density does not exceed 30% of a saturation flux density of the magnetic core.

In a preferred embodiment, the magnitude of the magnetic bias field does not exceed four times the coercivity of the magnetic core and/or the bias magnetic flux density does not exceed 10% of the saturation flux density of the magnetic core.

In a preferred embodiment, the inductive device comprises a separation filter, being configured to separate the bias signal from the main operation signal.

In a preferred embodiment, the alternating bias source comprises an oscillator, a broadband source or a white noise generator combined with a bandpass filter. Preferably, the bias signal is a periodic waveform, in particular a sine, square or saw-tooth, or a band pass filtered white noise.

In a preferred embodiment, the inductive device comprises at least one primary winding around the magnetic core, to which the main operation signal is applied, a magnetic transducer, being configured to measure a magnetic field in the magnetic core, at least one secondary winding around the magnetic core, a signal driver, being configured to apply a compensation signal to the second winding, such that a magnetic compensation field produced by the compensation signal cancels the main operation field, wherein the compensation signal comprises the electrical bias signal.

Such inductive devices include inductive transducers, electrical transformers, or current sensors like closed loop current sensors. Examples of inductive transducers include proximity sensors, position sensors like linear variable differential transformers, angular displacement sensors like rotary variable differential transformer, elasto-magnetic sensors, etc. Electrical transformers can be for example voltage or current transformers.

Preferably, the inductive device comprises a magnetic core provided with one or more windings, one winding carrying a main electrical signal, means to measure the current or voltage in one or more windings, and means to produce a high frequency bias current into one winding.

### BRIEF DESCRIPTION OF THE DRAWINGS

The subject matter of the invention will be explained in more detail in the following text with reference to preferred embodiments, which are illustrated in the attached drawings, in which:
Fig.1 shows a schematic view of an inductive device of the prior art;
Fig.2 shows a schematic view of an inductive device of a first, embodiment;
Fig.3 shows a schematic view of an inductive device of a second, embodiment;
Fig.4 shows a schematic view of an inductive device of a third, embodiment;
Fig.5 shows a schematic view of an inductive device of a fourth a embodiment;
Fig.6 shows a schematic view of an inductive device of fifth embodiment;
Fig.7 shows a schematic view of an inductive device of a sixth embodiment;
Fig.8 shows a schematic view of an inductive device of a seventh embodiment;
Fig.9 shows a schematic view of an inductive device of an eighth embodiment; and
Fig.10 shows a schematic view of an inductive device of a ninth embodiment.

The reference symbols used in the drawings, and their meanings, are listed in summary form in the list of reference symbols. In principle, identical parts are provided with the same reference symbols in the figures.

### DETAILED DESCRIPTION OF PREFERRED EMBODIMENTS

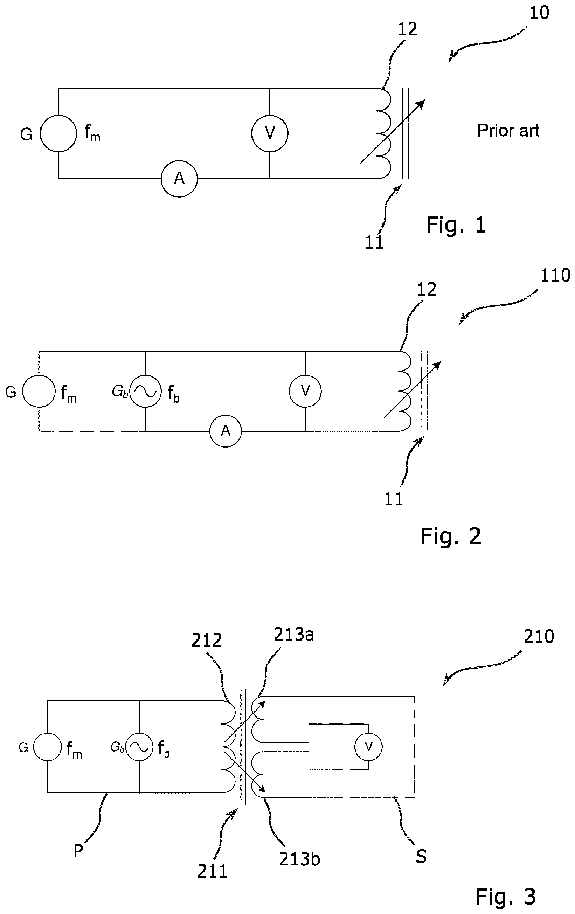

Fig. 1 shows an inductive device 10 comprising a magnetic core 11 according to the prior art. The inductive device 10 is configured as a variable inductance sensor such like an inductive position sensor or an elasto-magnetic sensor.

An inductance of the inductive position sensor depends on the position of a magnetic object with respect to a primary winding 12, where the primary winding 12 can be applied around a magnetic structure. The magnetic structure and the magnetic object are part of the magnetic core 11.

A magnetic permeability and an inductance of the elasto-magnetic sensor varies with the elastic stress and/or elastic deformation acting on a magnetic structure, being part of the magnetic core 11 which is coupled to the electrical primary winding 12.

In any case, the winding primary 12 is energized by an alternating electrical main operation signal having a main operation frequency fₘ. The main operation signal is produced by a main voltage generator G, being a voltage source. Alternatively, the main operation signal is produced by a current source. The impedance and/or inductance of the variable inductance sensor can be determined by measuring a current signal and/or a voltage signal produced at the primary winding 12 by an ampere meter A and/or a voltage meter V, respectively.

Fig. 2 shows an inductive device 110 according to a first embodiment. In this embodiment, the inductive device 110 is configured as a variable inductance sensor such like an inductive position sensor or an elasto-magnetic sensor, as already shown in Fig. 1.

Additionally, a high frequency bias signal is superimposed to the main operation signal in order to improve the magnetic response of the magnetic core 11 experienced by the main operation signal. From an equivalent circuit point of view, the bias signal is provided by a high frequency bias signal source, which can be seen as an equivalent bias voltage generator G_{b} in parallel to the equivalent main voltage generator G of the main operation signal. However, practical implementations may be different and could employ other generator types and/or different circuit architectures. It is possible, for example, to use one generator for producing both the main electrical signal and the high frequency bias signal.

The high frequency signal "consumes" irreversible magnetization effects such that the main operation signal experiences mainly reversible magnetization processes. The main operation signal is provided thus with an idealized behaviour of the magnetic core, where hysteresis effects, non-linear B-H curve, and Barkhausen noise are minimized or eliminated. Better linearity, better reproducibility, lower magnitude errors, and lower phase errors are thus achieved, resulting in much improved measurement accuracy.

The solution is relatively easy to implement, as generating a high frequency bias signal is uncomplicated. For example, the same circuitry for producing the main operation signal or a significant part of it is preferably used for producing the bias signal. The bias frequency f_{b} preferably is sufficiently high in order to have little effect on the processing of the main operation signal being applied for the measurement. For example, the bias frequency f_{b} is ten times higher than the main operation frequency fₘ. In order to keep the magnetic core far from saturation, the magnitude of the bias signal is selected to be sufficiently small, which also minimizes the impact of the bias signal on the signal processing applied in the inductive device 110.

Preferably, the inductive device 110 comprises a low-pass filter and/or a band-pass filter, if it is necessary to better separate the bias signal from the main operation signal for processing the measurement values. The low-pass filter and/or the band-pass filter is preferably implemented in hardware or in software.

Fig. 3 shows an inductive device 210 comprising a magnetic core 211 according to a second embodiment. The inductive device 210 is configured as a variable differential transformer, which is employed for example in linear variable differential transformers, rotary variable differential transformers, or elasto-magnetic sensors.

The variable differential transformer comprises a primary circuit P with a primary winding 212 around the magnetic core 211 to which a primary signal with a main operation frequency fₘ is applied and a secondary circuit S with a secondary winding 213a, 213b around the magnetic core 211 to which a secondary signal is applied. The secondary signal of the variable differential transformer preferably depends on the position of a magnetic structure, which is part of the magnetic core 211, with respect to the secondary winding 213a, 213b, which is configured as two secondary windings 213a, 213b, which are connected in differential mode in order to provide higher sensitivity and to almost eliminate the common mode signal. Thus, variable differential transformers can provide significantly better resolution and accuracy than variable inductance sensors. However, their performance is often limited in practice by suboptimal behaviour of the magnetic core 211 related to hysteresis effects, non-linear B-H curve, and/or Barkhausen noise. It is thus highly beneficial to improve the magnetic response of the magnetic core by providing a high frequency bias signal with a bias frequency fb, preferably provided by a bias voltage generator G_{b}, in the primary circuit P following similar approaches as already described for the variable inductance sensor of Fig. 2.

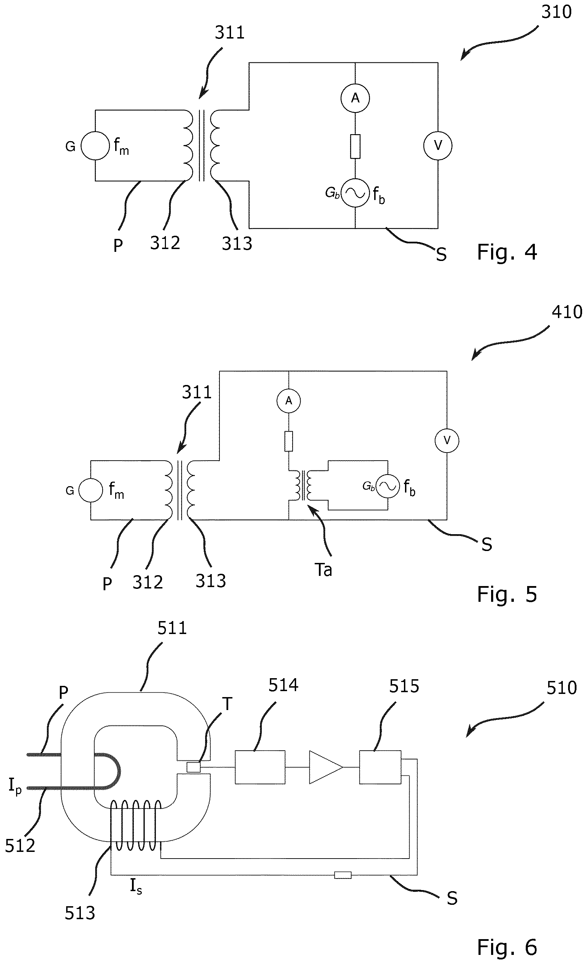

Fig. 4 shows an inductive device 310 comprising a magnetic core 311 according to a third embodiment. The inductive device 310 is configured as a signal transformer. The term signal transformer, as used herein, covers various types of current transformers and/or voltage transformers, in particular including instrument transformers. The signal transformer comprises a primary circuit P with a primary winding 312, to which a primary signal with a main operation frequency fₘ is applied and a secondary circuit S with a secondary winding 313, to which a secondary signal is applied. The primary signal preferably is the main operation signal applied to the transformer. The secondary signal preferably is an image of the primary signal. The primary signal preferably has a main operation frequency fₘ, in particular around 50 Hz. The secondary signal is ideally proportional to the primary signal according to an accurate, linear, and reproducible transformation ratio. However, it is known in practice that the transformation ratio is affected by magnitude and phase errors caused by the magnetic hysteresis of the magnetic core. The non-linear B-H curve causes measurement errors, which depend on the magnitude of the primary signal. For example, the measurement errors increase at smaller primary signals because the initial permeability of the magnetic core is smaller than its maximum permeability. Further, the value of the initial permeability depends on the magnetization state of the magnetic core, being lower if the magnetic core is in a remanent magnetized state. The residual magnetization would also limit the operation range of the transformer. The response of the signal transformer is thus non-linear and non-reproducible, causing limited accuracy and reduced measurement range of the device.

The secondary circuit S of the transformer can be thus provided with a bias voltage generator G_{b} or a current generator for producing the bias signal. The secondary circuit S preferably also comprises a voltage meter V and/or a current meter A and an appropriate electrical burden depending on the type and purpose of the transformer.

Fig. 5 shows an inductive device 410 as shown in Fig. 4 according to a fourth embodiment. In some cases, it can be beneficial to produce the high frequency bias signal in the secondary circuit S of the signal transformer by coupling through an auxiliary transformer Ta. Using an auxiliary transformer Ta, which can be seen as a coupling transformer, provides flexibility to easily match impedance and signal levels. It also allows separating the secondary circuit of the signal transformer from the bias voltage generator G_{b} enabling functionalities such as electrical insulation and/or filtering. Since bias frequency fb is relatively high, e.g. between 500 Hz to 50 kHz, the auxiliary transformer would be small and economical. The solution preferably allows thus to improve the performance of the signal transformer and saving cost and complexity on the construction of the signal transformer, allowing for better overall performance and competitive cost.

The accuracy and the operation range of the signal transformer can be drastically improved by applying the bias signal in order to improve the response of the magnetic core experienced by the main electrical signal. The magnitude and phase accuracy errors caused by the magnetic hysteresis at the characteristic frequency of the transformer can be thus eliminated or drastically reduced. Almost constant permeability of the magnetic core is achieved from very small value of the main operation signal up to saturation, without being affected by the history of the magnetization signals applied to the magnetic core. The Barkhausen noise is also removed from frequencies close to the main operation frequency fₘ. Very high accuracy, wide operation range, excellent linearity and reproducibility are thus achieved even with common magnetic materials. In a signal transformer, it can be beneficial to apply the high frequency bias signal in the secondary circuits. This has practical implementation benefits but would also allow to concentrate the energy of the bias signal in the magnetic bias field produced in the magnetic core and to minimize the signal produced in the primary circuit.

Fig. 6 shows an inductive device 510 comprising a magnetic core 511 according to a fifth embodiment. The inductive device 510 is configured as a closed loop current sensor, also known as zero-flux current sensor. The closed loop current sensor comprises a primary circuit P with a primary winding 512, to which a primary signal with a main operation frequency fₘ is applied and a secondary circuit S with a secondary winding 513, to which a secondary signal is applied.

Closed loop current sensors allow measuring both a DC and an AC primary current Iₚ flowing in the primary circuit. The closed looped current sensors additionally comprises a magnetic transducer T to sense magnetic flux in the magnetic core 511, a suitable processing unit 514, and a drive unit 515 to apply a secondary current Iₛ, comprising a compensation current in the secondary winding S in order to cancel the magnetic flux produced by the primary current Iₚ. The processing unit 514 and the drive unit 515 preferably are analogue circuits and/or integrated circuits, in particular processors. The sensor is usually designed to actively compensate the flux induced by the primary current Iₚ at DC and low frequency. At high frequency, the sensor is usually designed to have passive compensation of the flux induced by the primary current Iₚ like in a current transformer. The compensation current is proportional to the primary current Iₚ and to the ratio of the turns, both for DC and AC current.

However, the accuracy of common closed loop current sensors is compromised by the non-linear response of the magnetic core, by the magnetic hysteresis of the magnetic core, and by the Barkhausen noise in the magnetic core. The impact of the non-linear response of the magnetic core on the accuracy of the sensor is reduced to a high extent by the closed loop principle of the sensor. However, non-linearity errors in the order of 0.1% are still common for DC operation and can be higher for AC operation. The remanent magnetic flux in the magnetic core 511 causes an error which is commonly known as magnetic offset error and which depends on the magnetization state of the magnetic core. The magnetic offset error depends on the magnetization state of the magnetic core 511. It has hysteretic origin and it is influenced by the history of the currents experienced by the current sensor and by the history of magnetic fields experienced by the magnetic core 511, including the fields created by sources external to the current sensor. The Barkhausen noise causes abrupt changes in the magnetization of the magnetic core material and may appear on the output of the current sensor as noise or sudden offset jumps. Because the magnetic offset depends on the history of the magnetic fields experienced by the magnetic core and on Barkausen jumps, it is not possible to calibrate it. The magnetic offset is a serious drawback of closed loop current sensors preventing their use in applications where accurate and reliable measurement of the DC current is needed.

Preferably, the magnetic core 511 features a gap and a magnetic transducer is located in the gap where it senses the magnetic flux density, which is representative for the magnetic flux in the magnetic core. The closed loop principle is attractive because it effectively eliminates most errors related to the magnetic transducer, allowing to use economical components such as Hall transducers or miniature fluxgate transducers.

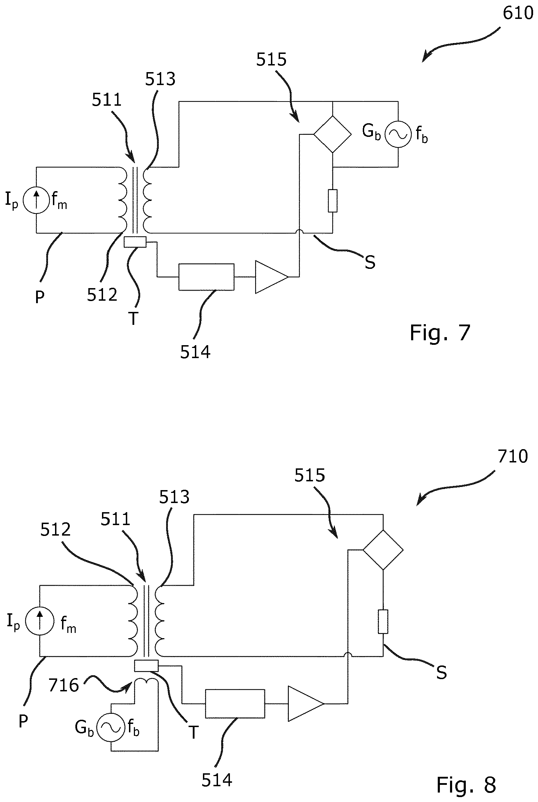

Fig. 7 shows an inductive device 610 as shown in Fig. 6 according to a sixth embodiment. The DC accuracy and the DC and AC linearity of the closed loop current sensor can be drastically improved by applying a high frequency magnetic bias field to the magnetic core 611 of the current sensor. As in the case of a signal transformer shown in Fig. 4 and Fig. 5, it is convenient to produce the high frequency bias signal in the secondary circuit S of the current sensor. The bias signal with a bias frequency fb is then superimposed to the compensation signal applied to the secondary winding S of the current sensor. From an equivalent circuit perspective, the equivalent bias voltage generator G_{b} of the high frequency bias signal can be arranged in parallel to the equivalent current generator or the drive unit 515 of the compensation signal. However, various implementations are possible in practice employing at least one voltage source, or at least one current source, or/and at least one auxiliary transformers.

The closed loop current sensor comprises a signal driver 515 to produce a compensation signal and a corresponding compensation current in the secondary winding S. The driver of the compensation signal is typically controlled by the signal from the processing unit 514 amplified by an amplifier, preferably an operational amplifier circuit. The amplifier, features generally high open loop gain in order to enable closed loop operation of the current sensor. The processing unit 514 conditions the signal from the magnetic transducer and possibly provides appropriate excitation signals to the magnetic transducer T. The magnetic transducer T is coupled to the magnetic core 511 and can measure directly or indirectly the value of the magnetic flux in the magnetic core 511.

In some implementations, it may be beneficial to use one single secondary driver to drive both the compensation signal and the high frequency bias signal. In this case, a simplified circuit can be employed for producing the high frequency bias waveform. The high frequency bias waveform can be added to the output of the processing unit 514 in order to apply it to the secondary driver, which would produce a signal in the secondary winding 513 comprising the compensation current and the bias current. There are many other possible ways to introduce the high frequency bias waveform in the secondary signal path of the current sensor.

Fig. 8 shows an inductive device 710 as shown in Fig. 6 and Fig. 7 according to an seventh embodiment. Additionally, it is possible to apply the high frequency bias waveform to a bias coil 716, which is inductively or magnetically coupled to the magnetic transducer T.

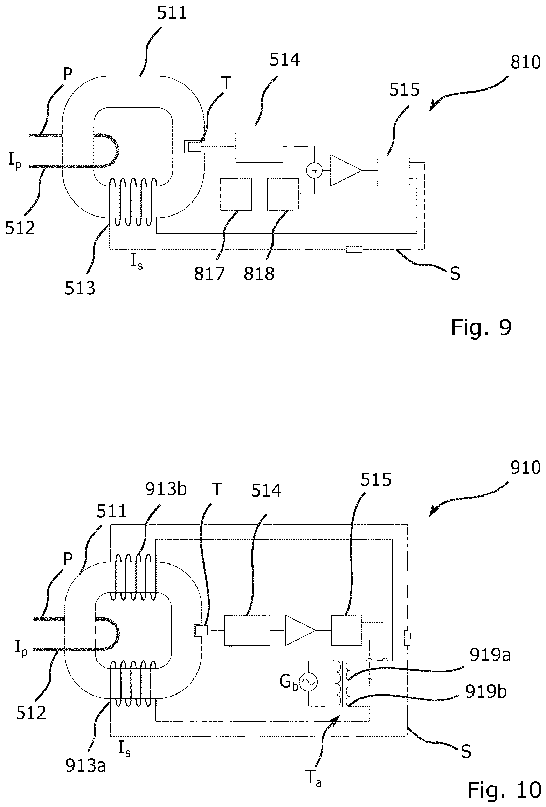

Fig. 9 shows an inductive device 810 as shown in Fig. 6 to Fig. 8 according to an eighth embodiment. The inductive device 810 additionally comprises a white noise generator 817 generating a bias signal which is broadband white noise allowing to reach high peak values and low power spectral density. The white noise bias waveform has multiple benefits concerning the practical implementation of the current sensor and the application where the sensor is being installed. One great benefit is that the peak magnitude of white noise is typically around 3 to 5 times higher than the rms value, depending on the time limit that applies. Other practical advantage is that white noise is extremely easy to implement, for example by amplifying the thermal noise of a resistor. Employing a white noise bias signal would also ensure compatibility to common applications of current sensors, as measures to deal with white noise are foreseen in most applications.

Thus, it is possible to avoid spurious signals caused by the bias signal in the secondary signal of the inductive device 810 by distributing the power of the bias signal over a wide frequency spectrum.

Preferably, the inductive device comprises a passband filter 818 to limit the frequency band of the white noise bias signal and should be scaled to ensure both efficient biasing and negligible disturbance of the application. For example, the white noise bias waveform may be implemented in a specific circuit and added to the signal coming from the processing unit 514. It is also possible to integrate the noise source in some functional block already present in common closed-loop current sensor. For example, one may scale a resistor in the biasing circuit of the Hall element or in some amplifier stage from the processing unit or from the drive unit in order to boost the white noise.

Fig. 10 shows an inductive device 910 as shown in Fig. 6 to Fig. 9 according to a ninth embodiment. The inductive device 910 according to the ninth embodiment comprises an auxiliary transformer Ta as shown in Fig. 5.

If the high frequency bias signal is introduced after the amplifier present in the secondary circuit S of the inductive device, the bias frequency shall be preferably higher than the bandwidth of the closed loop compensation circuit, in order to avoid that the bias current is countered by the compensation current. If the bias frequency is very high, e.g. between 1 kHz and 50 kHz, the bias voltage which needs to be applied to the secondary winding S may have to be sufficiently high in order to overcome the impedance of the winding which is proportional to the frequency. This is the case even when small bias currents must be produced, as it is mainly considered here. Much flexibility for selecting an appropriate magnitude of the bias voltage can be achieved by using an auxiliary transformer Ta to couple the bias signal into the path of the secondary current Iₛ of the current sensor.

Preferably, a balanced configuration is employed, where the auxiliary transformer Ta features two secondary auxiliary transformer windings 919a, 919b. Each secondary auxiliary transformer winding 919a, 919b of the auxiliary transformer Ta can be symmetrically arranged with respect to the drive unit 515 of the current sensor, to avoid bringing the output voltage of the drive unit 515 outside the supply rails of the circuit. Clamping diodes can also be employed on the outputs of the drive unit 515 to ensure that this scope is reached. The drive unit 515 would also preferably feature a differential output. The balanced and symmetrical configuration of the closed loop current sensor can be extended by employing two secondary windings 913a, 913b connected in series with the measuring resistor in-between.

For a closed loop current sensor as described in Fig. 6 to Fig. 10, the main operation frequency fₘ of the primary signal, or main operation signal, is closed to DC and can be considered to be around 0.1 Hz. The bias frequency fb can generally be selected to be comprised in a range from 100 Hz to 50 kHz, however, the precise bias frequency fb would depend on the target application and overall sensor design. The bias frequency fb can overlap with or be comprised within an operation frequency range of the current sensor without negative impact on the sensor operation. The magnitude of the high frequency magnetic bias field created in the magnetic core must be comparable or slightly higher than the coercivity of the magnetic core in order to achieve all benefits mentioned in the disclosure. The corresponding bias current in the secondary circuit would be much smaller than the compensation current reached during normal operation of the current sensor. Moreover, the frequency of the bias current can be selected in a frequency range where the performance requirements for the current sensor are more relaxed. For example, closed loop current sensors are often required to provide optimum performance in a frequency range from DC to 50 Hz, and less stringent requirements apply from 50 Hz to 100 kHz. It can be judicious in such case to select a bias frequency comprised between 500 Hz and 10 kHz.

The magnitude required for the high frequency magnetic bias field and for the corresponding bias current can be further reduced by employing magnetic cores with very low coercivity. Magnetic cores 511 having low coercivity and low losses at high frequency would then be preferred, making amorphous alloys or nanocrystalline alloys very attractive. Magnetic cores 511 made from nanocrystalline alloys, feature appealing combination of great magnetic properties and acceptable cost. Using magnetic cores with coercivity values below 2 A/m would be typically preferred.

The magnetic cores 511 in common closed loop current sensors are usually provided with a full gap, meaning that the magnetic path of the magnetic core is fully interrupted. Alternatively, it is possible to provide the magnetic core 511 with a partial gap which does not extend over the whole cross-section of the magnetic core 511 but it only reduces locally the cross-section of the magnetic core 511. Using a partial gap is of interest in the present disclosure because it allows using a smaller bias current to reach a given magnetic bias field in the magnetic as compared to a full gap. The purpose here is to minimize the bias current for reaching the desired magnetic bias field. The magnetic transducer may be placed in the partial gap or in close proximity to the partial gap. The partial gap would be typically provided like a cut or a slit in the cross-section of the magnetic core. For example, the width of the cut may be comprised between 0.1 mm and 2 mm. The depth of the cut may be such that it locally reduces the cross-section of the magnetic core 511 by around 10% to 90%. It is also possible to implement a partial gap by using other means and geometries to locally reduce the cross-section of the magnetic core 511.

### LIST OF REFERENCE SYMBOLS

- 10: inductive device
- 11: magnetic core
- 12: winding
- 110: inductive device
- 210: inductive device
- 211: magnetic core
- 212: primary winding
- 213a: secondary winding
- 213b: secondary winding
- 310: inductive device
- 311: magnetic core
- 312: primary winding
- 313: secondary winding
- 410: inductive device
- 510: inductive device
- 511: magnetic core
- 512: primary winding
- 513: secondary winding
- 514: processing unit
- 515: drive unit
- 610: inductive device
- 710: inductive device
- 716: bias coil
- 810: inductive device
- 817: white noise generator
- 818: band pass filter
- 910: inductive device
- 913a: secondary winding
- 913b: secondary winding
- 919a: secondary auxiliary transformer winding
- 919b: secondary auxiliary transformer winding
- G: main voltage generator
- G_{b}: bias voltage generator
- A: ampere meter
- V: volt meter
- fₘ: main operation frequency
- f_{b}: bias frequency
- P: primary circuit
- S: secondary circuit
- Iₚ: primary current
- Iₛ: secondary current
- Ta: auxiliary transformer

## Claims

1. Method for operating an inductive device 2. (110) with a magnetic core (11),
comprising the steps:
Operating the inductive device (110) by an electrical main operation signal with a main operation frequency (fₘ) producing a magnetic main operation field in the magnetic core (11);
Providing an alternating electrical bias signal with a bias frequency (f_{b}) higher than the main operation frequency (fₘ) producing a magnetic bias field in the magnetic core (11) superimposed to the magnetic main operation field, such that non-linear and/or hysteresis effects in the magnetic core (11) are shifted from the main operation frequency (fₘ) to the bias frequency (f_{b}); wherein
the magnetic bias field is simultaneously superimposing the magnetic main operation field.

2. Method of claim 1, wherein
the bias frequency (f_{b}) is at least ten times higher than the main operation frequency (fₘ); wherein preferably
the bias frequency (f_{b}) is at least one hundred times higher than the main operation frequency (fₘ); wherein further preferably
the bias frequency (f_{b}) is between 100 Hz and 50kHz.

3. Method of any of the claims 1 or 2, wherein
the magnitude of the magnetic bias field is at least 0.2 A/m; wherein preferably
the magnitude of the magnetic bias field is larger than a coercivity of the magnetic core (11).

4. Method of any of the claims 1 to 3, wherein
the magnetic bias field produces a bias magnetic flux density in the magnetic core (11); wherein
the bias magnetic flux density does not exceed 30% of a saturation flux density of the magnetic core (11).

5. Method of any of the claims 3 or 4, wherein
the magnitude of the magnetic bias field does not exceed four times the coercivity of the magnetic core (11) and/or the bias magnetic flux density does not exceed 10% of the saturation flux density of the magnetic core (11).

6. Method of any of the claims 1 to 5, wherein
the bias signal is a periodic waveform, in particular a sine, square or saw-tooth, or a band pass filtered white noise.

7. Inductive device (110, 510, 810) comprising:
a magnetic core (11, 511, 811)
an alternating bias source (G_{b}), wherein
the inductive device (110) is configured to be operated by an electrical main operation signal with an main operation frequency (fₘ) producing a magnetic main operation field in the magnetic core (11); wherein
the alternating bias source (G_{b}) is configured to provide an alternating electrical bias signal with a bias frequency (f_{b}) higher than the main operation frequency (fₘ) producing a magnetic bias field in the magnetic core (11) superimposed to the magnetic main operation field, such that non-linear and/or hysteresis effects in the magnetic core (11) are shifted from the main operation frequency (fₘ) to the bias frequency (f_{b}); wherein
the magnetic bias field is simultaneously superimposing the magnetic main operation field.

8. Inductive device of claim 7, wherein
the bias frequency (f_{b}) is at least ten times higher than the main operation frequency (fₘ); wherein preferably
the bias frequency (f_{b}) is at least one hundred times higher than the main operation frequency (fₘ); wherein further preferably
the bias frequency (f_{b}) is between 100 Hz and 50kHz.

9. Inductive device of any of the claims 7 or 8, wherein
the magnitude of the magnetic bias field is at least 0.2 A/m; wherein preferably
the magnitude of the magnetic bias field is larger than a coercivity of the magnetic core (11).

10. Inductive device of any of the claims 7 to 9, wherein The magnetic bias field produces a bias magnetic flux density in the magnetic core (11); wherein
the bias magnetic flux density does not exceed 30% of a saturation flux density of the magnetic core (11).

11. Inductive device of any of the claims 7 to 10; wherein
the magnitude of the magnetic bias field does not exceed four times the coercivity of the magnetic core (11) and/or the bias magnetic flux density does not exceed 10% of the saturation flux density of the magnetic core (11).

12. Inductive device, of any of the claims 7 to 11, comprising:
a separation filter, being configured to separate the bias signal from the main operation signal.

13. Inductive device of any of the claims 7 to 12, wherein
the alternating bias source (G_{b}) comprises an oscillator, a broadband source or a white noise generator (817) combined with a bandpass filter (818); wherein preferably
the bias signal is a periodic waveform, in particular a sine, square or saw-tooth, or a band pass filtered white noise.

14. Inductive device, of any of the claims 7 to 13, comprising:
at least one primary winding (P) around the magnetic core (511), to which the main operation signal is applied;
a magnetic transducer (T), being configured to measure a magnetic field in the magnetic core (511);
at least one secondary winding (S) around the magnetic core (511);
a signal driver (515)
being configured to apply a compensation signal to the second
winding (S), such that a magnetic compensation field produced by the compensation signal cancels the main operation field; wherein
the compensation signal comprises the electrical bias signal.

## Patentansprüche

1. Verfahren zum Betreiben einer induktiven Vorrichtung (110) mit einem Magnetkern (11), umfassend die Schritte:
Betreiben der induktiven Vorrichtung (110) durch ein elektrisches Hauptbetriebssignal mit einer Hauptbetriebsfrequenz (fm), die ein magnetisches Hauptbetriebsfeld in dem Magnetkern (11) erzeugt;
Bereitstellen eines alternierenden elektrischen Vormagnetisierungssignals mit einer Vormagnetisierungsfrequenz (fb), die höher als die Hauptbetriebsfrequenz (fm) ist und ein magnetisches Vormagnetisierungsfeld in dem Magnetkern (11) erzeugt, das dem magnetischen Hauptbetriebsfeld überlagert ist, so dass nichtlineare und/oder Hystereseeffekte in dem Magnetkern (11) von der Hauptbetriebsfrequenz (fm) zu der Vormagnetisierungsfrequenz (fb) verschoben werden; wobei
das magnetische Vormagnetisierungsfeld simultan das magnetische Hauptbetriebsfeld überlagert.

2. Verfahren nach Anspruch 1, wobei
die Vormagnetisierungsfrequenz (fb) mindestens zehnmal höher ist als die Hauptbetriebsfrequenz (fm), wobei vorzugsweise
die Vormagnetisierungsfrequenz (fb) mindestens einhundertmal höher ist als die Hauptbetriebsfrequenz (fm); wobei weiter bevorzugt
die Vormagnetisierungsfrequenz (fb) zwischen 100 Hz und 50kHz liegt.

3. Verfahren nach einem der Ansprüche 1 oder 2, wobei
die Größenordnung des magnetischen Vormagnetisierungsfeldes mindestens 0,2 A/m beträgt; wobei vorzugsweise
die Größenordnung des magnetischen Vormagnetisierungsfeldes größer ist als eine Koerzitivfeldstärke des Magnetkerns (11).

4. Verfahren nach einem der Ansprüche 1 bis 3, wobei
das magnetische Vormagnetisierungsfeld eine Vormagnetisierungsflußdichte in dem Magnetkern (11) erzeugt; wobei
die Vormagnetisierungsflußdichte 30% einer Sättigungsflußdichte des Magnetkerns (11) nicht überschreitet.

5. Verfahren nach einem der Ansprüche 3 oder 4, wobei
die Größenordnung des Vormagnetisierungsfeldes das Vierfache der Koerzitivfeldstärke des Magnetkerns (11) nicht überschreitet und/oder die Vormagnetisierungsflußdichte 10 % der Sättigungsflußdichte des Magnetkerns (11) nicht überschreitet.

6. Verfahren nach einem der Ansprüche 1 bis 5, wobei
das Vormagnetisierungssignal eine periodische Wellenform ist, insbesondere ein Sinus, ein Rechteck oder ein Sägezahn, oder ein bandpassgefiltertes weißes Rauschen.

7. Induktive Vorrichtung (110, 510, 810), umfassend:
einen Magnetkern (11,511,811);
eine alternierende Vormagnetisierungsquelle (Gb), wobei
die induktive Vorrichtung (110) derart eingerichtet ist, dass sie durch ein elektrisches Hauptbetriebssignal mit einer Hauptbetriebsfrequenz (fm) betrieben wird, die ein magnetisches Hauptbetriebsfeld in dem Magnetkern (11) erzeugt; wobei
die Vormagnetisierungsquelle (Gb) derart eingerichtet ist, dass sie ein wechselndes elektrisches Vormagnetisierungssignal mit einer Vormagnetisierungsfrequenz (fb) bereitstellt, die höher als die Hauptbetriebsfrequenz (fm) ist, und ein magnetisches Vormagnetisierungsfeld in dem Magnetkern (11) erzeugt, das dem magnetischen Hauptbetriebsfeld überlagert ist, so dass nichtlineare und/oder Hystereseeffekte in dem Magnetkern (11) von der Hauptbetriebsfrequenz (fm) zu der Vormagnetisierungsfrequenz (fb) verschoben werden; wobei
das magnetische Vormagnetisierungsfeld simultan das magnetische Hauptbetriebsfeld überlagert.

8. Induktive Vorrichtung nach Anspruch 7, wobei
die Vormagnetisierungsfrequenz (fb) mindestens zehnmal höher ist als die Hauptbetriebsfrequenz (fm), wobei vorzugsweise
die Vormagnetisierungsfrequenz (fb) mindestens einhundertmal höher ist als die Hauptbetriebsfrequenz (fm); wobei weiter bevorzugt
die Vormagnetisierungsfrequenz (fb) zwischen 100 Hz und 50kHz liegt.

9. Induktive Vorrichtung nach einem der Ansprüche 7 oder 8, wobei die Größenordnung des magnetischen Vormagnetisierungsfeldes mindestens 0,2 A/m beträgt; wobei vorzugsweise
die Größenordnung des magnetischen Vormagnetisierungsfeldes größer ist als eine Koerzitivfeldstärke des Magnetkerns (11).

10. Induktive Vorrichtung nach einem der Ansprüche 7 bis 9, wobei
das magnetische Vormagnetisierungsfeld eine Vormagnetisierungsflussdichte in dem Magnetkern (11) erzeugt; wobei
die Vormagnetisierungsflußdichte 30% einer Sättigungsflußdichte des Magnetkerns (11) nicht überschreitet.

11. Induktive Vorrichtung nach einem der Ansprüche 7 bis 10, wobei
die Größenordnung des Vormagnetisierungsfeldes das Vierfache der Koerzitivfeldstärke des Magnetkerns (11) nicht überschreitet und/oder die Vormagnetisierungsflußdichte 10 % der Sättigungsflußdichte des Magnetkerns (11) nicht überschreitet.

12. Induktive Vorrichtung nach einem der Ansprüche 7 bis 11, umfassend:
einen Trennfilter, der derart eingerichtet ist, dass er das Vormagnetisierungssignal von dem Hauptbetriebssignal trennt.

13. Induktive Vorrichtung nach einem der Ansprüche 7 bis 12, wobei
die alternierende Vormagnetisierungsquelle (Gb) einen Oszillator, eine Breitbandquelle oder einen Generator für weißes Rauschen (817) in Kombination mit einem Bandpassfilter (818) umfasst; wobei vorzugsweise
das Vormagnetisierungssignal eine periodische Wellenform ist, insbesondere ein Sinus, ein Rechteck oder ein Sägezahn, oder ein bandpassgefiltertes weißes Rauschen.

14. Induktive Vorrichtung nach einem der Ansprüche 7 bis 13, umfassend:
mindestens eine Primärwicklung (P) um den Magnetkern (511), der das Hauptbetriebssignal zugeführt wird;
einen magnetischen Wandler (T), der derart eingerichtet ist, dass er ein Magnetfeld in dem Magnetkern (511) misst;
mindestens eine Sekundärwicklung (S) um den Magnetkern (511);
einen Signaltreiber (515), der derart eingerichtet ist, dass er ein Kompensationssignal an die Sekundärwicklung (S) anlegt, so dass ein durch das Kompensationssignal erzeugtes magnetisches Kompensationsfeld das Hauptbetriebsfeld auslöscht; wobei
das Kompensationssignal das elektrische Vormagnetisierungssignal umfasst.

## Revendications

1. Procédé pour faire fonctionner un dispositif inductif (110) avec un noyau magnétique (11), comprenant les étapes :
la mise en fonctionnement du dispositif inductif (110) par un signal de fonctionnement principal électrique avec une fréquence de fonctionnement principale (fₘ) produisant un champ de fonctionnement principal magnétique dans le noyau magnétique (11) ;
la fourniture d'un signal de polarisation électrique alternatif avec une fréquence de polarisation (f_{b}) plus haute que la fréquence de fonctionnement principale (fₘ) produisant un champ de fréquence magnétique dans le noyau magnétique (11) superposé sur le champ de fonctionnement principal magnétique, de telle sorte que des effets non linéaires et/ou d'hystérèse dans le noyau magnétique (11) soient décalés, de la fréquence de fonctionnement principale (fₘ) à la fréquence de polarisation (f_{b}) ; dans lequel
le champ de fréquence magnétique est simultanément superposé sur le champ de fonctionnement principal magnétique.

2. Procédé selon la revendication 1, dans lequel
la fréquence de polarisation (f_{b}) est au moins dix fois plus haute que la fréquence de fonctionnement principale (fₘ) ; dans lequel de préférence
la fréquence de polarisation (f_{b}) est au moins cent fois plus haute que la fréquence de fonctionnement principale (fₘ) ; dans lequel en outre de préférence
la fréquence de polarisation (f_{b}) est entre 100 Hz et 50 kHz.

3. Procédé selon l'une quelconque des revendications 1 ou 2, dans lequel
l'amplitude du champ de fréquence magnétique est d'au moins 0,2 A/m ; dans lequel de préférence
l'amplitude du champ de fréquence magnétique est supérieure à une coercivité du noyau magnétique (11).

4. Procédé selon l'une quelconque des revendications 1 à 3, dans lequel
le champ de fréquence magnétique produit une densité de flux magnétique de polarisation dans le noyau magnétique (11) ; dans lequel
la densité de flux magnétique de polarisation ne dépasse pas 30 % d'une densité de flux de saturation du noyau magnétique (11).

5. Procédé selon l'une quelconque des revendications 3 ou 4, dans lequel
l'amplitude du champ de fréquence magnétique ne dépasse pas quatre fois la coercivité du noyau magnétique (11) et/ou la densité de flux magnétique de polarisation ne dépasse pas 10 % de la densité de flux de saturation du noyau magnétique (11).

6. Procédé selon l'une quelconque des revendications 1 à 5, dans lequel
le signal de polarisation est une forme d'onde périodique, en particulier sinusoïdale, carrée ou en dent de scie, ou un bruit blanc ayant subi un filtrage passe-bande.

7. Dispositif inductif (110, 510, 810), comprenant :
un noyau magnétique (11, 511, 811) ;
une source de polarisation alternative (G_{b}), dans lequel
le dispositif inductif (110) est configuré pour être mis en fonctionnement par un signal de fonctionnement principal électrique avec une fréquence de fonctionnement principale (fₘ) produisant un champ de fonctionnement principal magnétique dans le noyau magnétique (11) ; dans lequel
la source de polarisation alternative (G_{b}) est configurée pour fournir un signal de polarisation électrique alternatif avec une fréquence de polarisation (f_{b}) plus haute que la fréquence de fonctionnement principale (fₘ) produisant un champ de fréquence magnétique dans le noyau magnétique (11) superposé sur le champ de fonctionnement principal magnétique, de telle sorte que des effets non linéaires et/ou d'hystérèse dans le noyau magnétique (11) soient décalés, de la fréquence de fonctionnement principale (fₘ) à la fréquence de polarisation (f_{b}) ; dans lequel
le champ de fréquence magnétique est simultanément superposé sur le champ de fonctionnement principal magnétique.

8. Dispositif inductif selon la revendication 7, dans lequel
la fréquence de polarisation (f_{b}) est au moins dix fois plus haute que la fréquence de fonctionnement principale (fₘ) ; dans lequel de préférence
la fréquence de polarisation (f_{b}) est au moins cent fois plus haute que la fréquence de fonctionnement principale (fₘ) ; dans lequel en outre de préférence
la fréquence de polarisation (f_{b}) est entre 100 Hz et 50 kHz.

9. Dispositif inductif selon l'une quelconque des revendications 7 ou 8, dans lequel
l'amplitude du champ de fréquence magnétique est d'au moins 0,2 A/m ; dans lequel de préférence
l'amplitude du champ de fréquence magnétique est supérieure à une coercivité du noyau magnétique (11).

10. Dispositif inductif selon l'une quelconque des revendications 7 à 9, dans lequel
le champ de fréquence magnétique produit une densité de flux magnétique de polarisation dans le noyau magnétique (11) ; dans lequel
la densité de flux magnétique de polarisation ne dépasse pas 30 % d'une densité de flux de saturation du noyau magnétique (11).

11. Dispositif inductif selon l'une quelconque des revendications 7 à 10 ; dans lequel
l'amplitude du champ de fréquence magnétique ne dépasse pas quatre fois la coercivité du noyau magnétique (11) et/ou la densité de flux magnétique de polarisation ne dépasse pas 10 % de la densité de flux de saturation du noyau magnétique (11).

12. Dispositif inductif, selon l'une quelconque des revendications 7 à 11, comprenant :
un filtre de séparation, configuré pour séparer le signal de polarisation du signal de fonctionnement principal.

13. Dispositif inductif selon l'une quelconque des revendications 7 à 12, dans lequel
la source de polarisation alternative (G_{b}) comprend un oscillateur, une source de large bande ou un générateur de bruit blanc (817) associé à un filtre passe-bande (818) ; dans lequel de préférence
le signal de polarisation est d'une forme d'onde périodique, en particulier sinusoïdale, carrée ou en dent de scie, ou un bruit blanc ayant subi un filtrage passe-bande.

14. Dispositif inductif, selon l'une quelconque des revendications 7 à 13, comprenant :
au moins un enroulement primaire (P) autour du noyau magnétique (511), sur lequel le signal de fonctionnement principal est appliqué ;
un transducteur magnétique (T), configuré pour mesurer un champ magnétique dans le noyau magnétique (511) ;
au moins un enroulement secondaire (S) autour du noyau magnétique (511) ;
un conducteur de signal (515) configuré pour appliquer un signal de compensation sur le second enroulement (S), de telle sorte qu'un champ de compensation magnétique produit par le signal de compensation annule le champ de fonctionnement principal ; dans lequel
le signal de compensation comprend le signal de polarisation électrique.
